# EUROPEAN PATENT APPLICATION

(11) **EP 0 874 454 A1**
(43) Date of publication of application: **28.10.1998**
(21) Application number: 98107064.2
(22) Date of filing: 17.04.1998
(51) Int. Cl.: H03H 9/05, H03H 9/17

(54) **Piezoelectric resonator and electronic component device using the same**

(30) Priority: 25.04.1997 JP 123277/97; 03.10.1997 JP 287669/97
(71) Applicant: MURATA MANUFACTURING CO., LTD., Nagaokakyo-shi Kyoto-fu (JP)
(72) Inventor: Ogawa, Mamoru, Nagaokakyo-shi, Kyoto-fu (JP); Nishimura, Toshio, Nagaokakyo-shi, Kyoto-fu (JP); Baba, Toshiyuki, Nagaokakyo-shi, Kyoto-fu (JP); Inoue, Jiro, Nagaokakyo-shi, Kyoto-fu (JP); Kusabiraki, Shigemasa, Nagaokakyo-shi, Kyoto-fu (JP); Takeshima, Tetsuo, Nagaokakyo-shi, Kyoto-fu (JP); Yamazaki, Takeshi, Nagaokakyo-shi, Kyoto-fu (JP)
(74) Representative: Gossel, Hans K., Dipl.-Ing.

(57) **Abstract**

The invention provides a piezoelectric resonator comprising a piezoelectric resonator element utilizing longitudinal vibration mode and having a mounting surface, wherein a resin material is provided on the mounting surface of said piezoelectric resonator element, and said resin material has a hardness of 0 to 50 in units defined in the JIS-A standards and/or an elastic modulus of 0.1 to 10 MPa.

## Description

The present invention relates to a piezoelectric resonator and an electronic component using the same, and more particularly to a piezoelectric resonator comprising a piezoelectric resonator element utilizing longitudinal vibration mode and having a mounting surface, and an electronic component using the same such as an oscillator, a discriminator, and a filter.

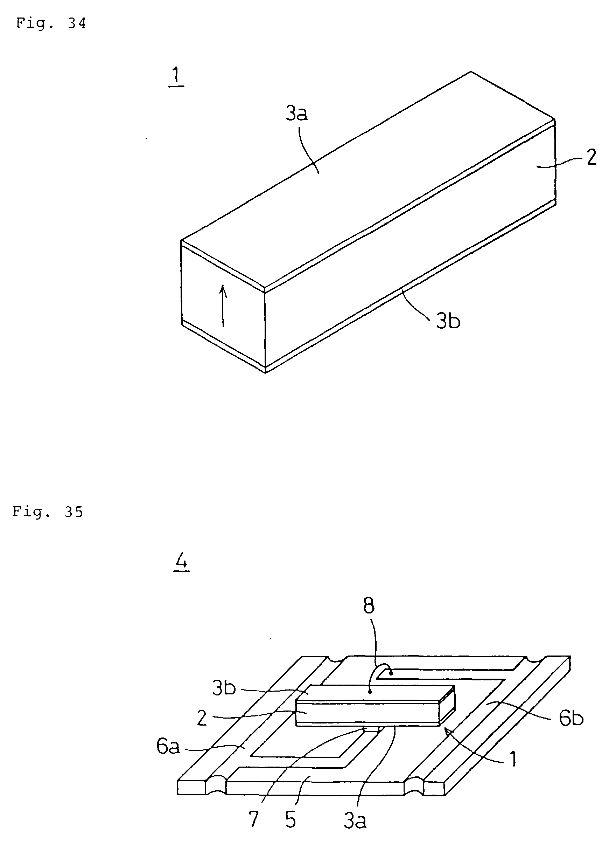

Fig. 34 of the drawings is a perspective view showing an example of a conventional piezoelectric resonator. The piezoelectric resonator 1 includes a rectangular-shaped piezoelectric body 2, and electrodes 3a and 3b are formed on two opposite side surfaces of the piezoelectric body 2. The piezoelectric body 2 disposed between the two electrodes 3a and 3b is polarized in a direction perpendicular to the major surfaces of the electrodes 3a and 3b as shown by an arrow in Fig. 34. In this piezoelectric resonator 1, longitudinal vibrations are generated when an excitation signal is applied between the two electrodes 3a and 3b.

An example of an electronic component device using this piezoelectric resonator 1 is shown in Fig. 35. This electronic component device 4 includes a substrate 5. The substrate 5 is made of an insulating material. Lead electrodes 6a and 6b are formed on the substrate 5. On one lead electrode 6a, there is provided a supporting member 7 made of for example a conductive material. The supporting member 7 is made of for example an epoxy-based conductive resin having a hardness of 50 or greater in units defined in the JIS-A standards and having an elastic modulus of 10 MPa or greater. The piezoelectric resonator 1 is fixed to the upper surface of the supporting member 7. One electrode 3a is connected to the supporting member 7 and the other electrode 3b is connected to a patterned electrode 6b via a lead wire 8.

The electronic component device 4 constructed in the above-described manner is used for example as a resonator, in which longitudinal vibration is generated in the piezoelectric resonator 1 when an excitation signal is applied between the electrode 3a and 3b. This property that longitudinal vibration is generated in response to the applied signal makes it possible to use the electronic component device 1 as a resonator or a discriminator.

In the above-described structure in which the piezoelectric resonator is supported by the supporting member, the supporting member causes leakage of vibration from the piezoelectric resonator, and the leakage of vibration can generate an anomaly such as a ripple in the characteristic. Furthermore, it is required that the supporting member should have a high-precision surface so that the piezoelectric resonator can be placed on it without generating a slant which would make the piezoelectric resonator brought into contact with the substrate thus interfering with the vibration of the resonator. To avoid such interference, it is required that the piezoelectric resonator should be mounted on the substrate in a firm and stable fashion for example by bonding the piezoelectric resonator at its both ends to the substrate via an adhesive such as a resin. However, if the piezoelectric resonator is bonded to the supporting member, the adhesive and the supporting member act as a load to the vibration. This means that when the piezoelectric resonator is bonded to the supporting member, a change occurs in the characteristics such as the mechanical quality factor Qm or the resonance frequency. To compensate for the change in the characteristics, it is required to make an adjustment after mounting the piezoelectric resonator on the substrate. In the conventional technique, as described above, the piezoelectric resonator has to be mounted so that it is supported in a stable fashion and the characteristics have to be adjusted after the mounting process. Thus, the disadvantage of the conventional technique is that complicated processes are required.

The main object of the invention therefore is to provide a piezoelectric resonator which can be mounted on a substrate or the like without encountering a significant change in the characteristics, and also provide a small-sized electronic component device having reliable characteristics, which can be easily produced.

This object by the invention is resolved by a piezoelectric resonator of the above mentioned kind, which is characterized in that a resin material is provided on the mounting surface of said piezoelectric resonator element, and said resin material has a hardness of 0 to 50 in units defined in the JIS-A standards and/or has an elastic modulus of 0.1 to 10 MPa.

In the piezoelectric resonator, said piezoelectric resonator may have a longitudinal direction, and said resin material is preferably located at least at the center in the longitudinal direction of said piezoelectric resonator element.

Preferably, the piezoelectric resonator element comprises a pair of external electrodes and a pair of electrically conductive resin materials are connected to said pair of external electrodes respectively at the center in the longitudinal direction of said piezoelectric resonator element.

In the above piezoelectric resonator, each of said pair of external electrodes may be plane shape, and said piezoelectric resonator element may comprise said pair of external electrodes and a piezoelectric body disposed between said external electrodes, and said piezoelectric body may be polarized in a direction perpendicular to the plane of said external electrodes.

In the above piezoelectric resonator, said piezoelectric resonator element may comprise a main body having a longitudinal direction, said main body comprises at least two plane shaped internal electrodes perpendicular to said longitudinal direction and a piezoelectric body disposed between said internal electrodes, said piezoelectric body may be polarized in a direction along the longitudinal direction of said main body, and said pair of internal electrodes are connected to said pair of external electrodes respectively.

The thermal expansion coefficient of the resin material is preferably substantially equal to that of the electrically conductive resin materials.

In the above piezoelectric resonator, said piezoelectric resonator element may comprise a main body having a longitudinal direction and a pair of external electrodes provided on the mounting surface of said main body or provided in such a manner that they are exposed at the mounting surface, and a pair of said resin material may be electrically conductive, disposed on the mounting surface of said main body, and electrically connected to said pair of external electrodes respectively.

The resin materials are preferably located at the center in the longitudinal direction of said piezoelectric resonator element on the mounting surface.

Each of said pair of external electrodes may be plane shape, said piezoelectric resonator element may comprise said pair of external electrodes and a piezoelectric body disposed between said external electrodes, and said piezoelectric body may be polarized in a direction perpendicular to the plane of said external electrodes.

Said piezoelectric resonator element may comprise a main body having a longitudinal direction, said main body may comprise at least two plane shaped electrodes perpendicular to said longitudinal direction and a piezoelectric body disposed between said plane shaped electrodes, said piezoelectric body may be polarized in a direction along the longitudinal direction of said main body, and said pair of plane shaped electrodes may be connected to said pair of external electrodes respectively.

The present invention further provides an electronic component device using the above described piezoelectric resonator, wherein said piezoelectric resonator is mounted on a substrate via said resin material.

The present invention further provides an electronic component device using the above described piezoelectric resonator, wherein said piezoelectric resonator is mounted on a substrate via said resin material, and said external electrodes are connected via said electrically conductive resin materials to lead electrodes provided on said substrate.

In this electronic component device, the electrically conductive resin materials of the piezoelectric resonator are preferably connected to the lead electrodes via an electrically conductive adhesive.

The present invention further provides an electronic component device, wherein said piezoelectric resonator is mounted on the substrate via said electrically conductive resin materials.

In this electronic component device, the external electrodes may be electrically connected, via the electrically conductive resin materials, to lead electrodes provided on the substrate.

Furthermore, the electrically conductive resin materials may be fixed via an electrically conductive adhesive to the lead electrodes, respectively.

In the above described electronic component device, a plurality of piezoelectric resonators may be disposed on the substrate and connected in such a manner as to form a ladder filter.

In the piezoelectric resonator having the structure in which the resin material is formed on the mounting surface of the piezoelectric resonator element utilizing longitudinal vibration mode, the resin material acts as a load associated with the longitudinal vibration of the piezoelectric resonator element. However, the load is substantially determined when the resin material acting as the load is formed on the piezoelectric resonator element in advance, and thus no further load to the longitudinal vibration is generated when the piezoelectric resonator element is mounted on the substrate via the resin material.

When longitudinal vibration occurs in the piezoelectric resonator, the center of the piezoelectric resonator element acts as a node of vibration. Therefore, it is preferable that the piezoelectric resonator be mounted on the substrate so that the piezoelectric resonator having the resin material formed thereon is supported at its central portion that acts as the node of vibration.

Furthermore, electronically conductive resin materials may be formed in such a manner that they are connected, at locations near the vibration node, to the external electrodes of the piezoelectric resonator element. In this case, the piezoelectric resonator element is mounted on the substrate in such a manner that the external electrodes are electrically connected via the electrically conductive resin materials to the lead electrodes formed on the substrate.

The piezoelectric resonator element may be mounted on the substrate via only the electrically conductive resin materials connected to the external electrodes. Also in this case, the electrically conductive resin materials act as the load to the longitudinal vibration of the piezoelectric resonator element. When the piezoelectric resonator element of this type is mounted on the substrate, the external electrodes can be electrically connected to the lead electrodes formed on the substrate via the electrically conductive resin materials.

The piezoelectric resonator element may be constructed either into the form in which electrodes are formed on two side surfaces of the piezoelectric body or into the form having a main body consisting of a plurality of piezoelectric bodies and electrodes disposed in a multilayer fashion.

In the case where both resin material and electrically conductive resin materials are formed on the piezoelectric resonator element, it is preferable that the resin material and the electrically conductive resin materials be similar or substantially same in the thermal expansion coefficient so that the electrically conductive resin materials do not peel off even if the piezoelectric resonator is used in an environment where ambient temperature varies.

In the electronic component device constructed using the piezoelectric resonator mounted on the substrate, if a resin material having a rather low hardness and/or small elastic modulus, then rather small mechanical coupling between the piezoelectric resonator and the substrate can be achieved thereby ensuring that no significant vibration leakage occurs from the piezoelectric resonator element to the substrate. Furthermore, because the resin material acting as the load to the vibration is formed in advance, the piezoelectric resonator encounters no significant change in the characteristics when it is mounted. Furthermore, electric connections between the piezoelectric resonator and the lead electrodes formed on the substrate can be achieved via the electrically conductive adhesive without having to use lead wires which are used in conventional electronic component devices.

Other features and advantages of the present invention will become apparent from the following description of the invention which refers to the accompanying drawings in which
- Fig. 1: is a perspective view illustrating an embodiment of a piezoelectric resonator according to the invention,
- Fig. 2: is a cross-sectional view of the piezoelectric resonator shown in Fig. 1,
- Fig. 3: is a perspective view illustrating an example of a piezoelectric resonator modified from that shown in Fig. 1,
- Fig. 4: is a perspective view illustrating another example of a piezoelectric resonator modified from that shown in Fig. 1,
- Fig. 5: is a perspective view illustrating another embodiment of a piezoelectric resonator according to the invention,
- Fig. 6: is a cross-sectional view of the piezoelectric resonator shown in Fig. 5,
- Fig. 7: is a plan view illustrating an example of the locations at which the electrically conductive materials are formed in the piezoelectric resonator shown in Fig. 5,
- Fig. 8: is a plan view illustrating another example of the locations at which the electrically conductive materials are formed in the piezoelectric resonator shown in Fig. 5,
- Fig. 9: is a perspective view illustrating an example of a piezoelectric resonator modified from that shown in Fig. 5,
- Fig. 10: is a perspective view illustrating another example of a piezoelectric resonator modified from that shown in Fig. 5,
- Fig. 11: is a perspective view illustrating an embodiment of an electronic component device using the piezoelectric resonator shown in Fig. 5,
- Fig. 12: is a perspective view illustrating another example of a piezoelectric resonator element for use in the piezoelectric resonator according to the invention,
- Fig. 13: is a schematic diagram illustrating the structure of the piezoelectric resonator element shown in Fig. 12,
- Figs. 14(a) and 14(b): are schematic diagrams illustrating the relationship between the piezoelectric bodies and the internal electrodes used in the piezoelectric resonator element shown in Fig. 12,
- Fig. 15: is a perspective view illustrating another embodiment of an electronic component device using the piezoelectric resonator shown in Fig. 12,
- Fig. 16: is a schematic diagram illustrating the positions of adhesives used to bond the piezoelectric resonator to the substrate in the electronic component device shown in Fig. 15,
- Fig. 17(a) and 17(b): are schematic diagrams illustrating another example of the positions of adhesives used to bond the piezoelectric resonator to the substrate in the electronic component device shown in Fig. 15,
- Fig. 18: is a perspective view illustrating still another example of a piezoelectric resonator element for use in the piezoelectric resonator according to the invention,
- Fig. 19: is a schematic view illustrating the structure of the piezoelectric resonator element shown in Fig. 18,
- Fig. 20: is a plan view schematically illustrating the structure of the piezoelectric resonator element shown in Fig. 18,
- Fig. 21: is a schematic diagram illustrating the positional relationship between the piezoelectric resonator and the lead electrodes formed on the substrate, in the electronic component device using the piezoelectric resonator having the piezoelectric resonator element shown in Fig. 18,
- Fig. 22: is a plan view illustrating the main parts of an electronic component device constructed into the form of a ladder fitter using a plurality of piezoelectric resonators,
- Fig. 23: is an exploded perspective view illustrating the main parts of the ladder filter shown in Fig 22,
- Fig. 24: is an equivalent circuit diagram of the ladder filter shown in Fig. 22,
- Fig. 25: is a graph illustrating Qm for a piezoelectric resonator element, a piezoelectric resonator having a resin material formed thereon, and an electronic component device comprising a piezoelectric resonator element mounted on a substrate,
- Fig. 26: is a graph illustrating Qm as a function of the thickness of the resin material of the piezoelectric resonator,
- Fig. 27: is a perspective view illustrating another embodiment of a piezoelectric resonator according to the invention,
- Fig. 28: is a schematic diagram illustrating the dimensions of supporting members formed on the piezoelectric resonator shown in Fig. 27,
- Fig. 29: is a schematic diagram illustrating the piezoelectric resonator shown in Fig. 27, wherein the piezoelectric resonator is mounted on a substrate,
- Fig. 30: is a schematic diagram illustrating the positional relationship between the piezoelectric resonator element and the supporting members in the piezoelectric resonator shown in Fig. 27,
- Fig. 31: is a perspective view illustrating still another embodiment according to the invention
- Fig. 32: is an exploded perspective view illustrating an embodiment of an electronic component device using a piezoelectric resonator having supporting members,
- Fig. 33: is an exploded perspective view illustrating an embodiment of an electronic component device constructed into the form of a ladder filter using piezoelectric resonators having supporting members,
- Fig. 34: is a perspective view illustrating an example of a conventional piezoelectric resonator and
- Fig. 35: is a perspective view illustrating an example of an electronic component device using the piezoelectric resonator shown in Fig. 34.

### PREFERRED EMBODIMENTS OF THE PRESENT INVENTION

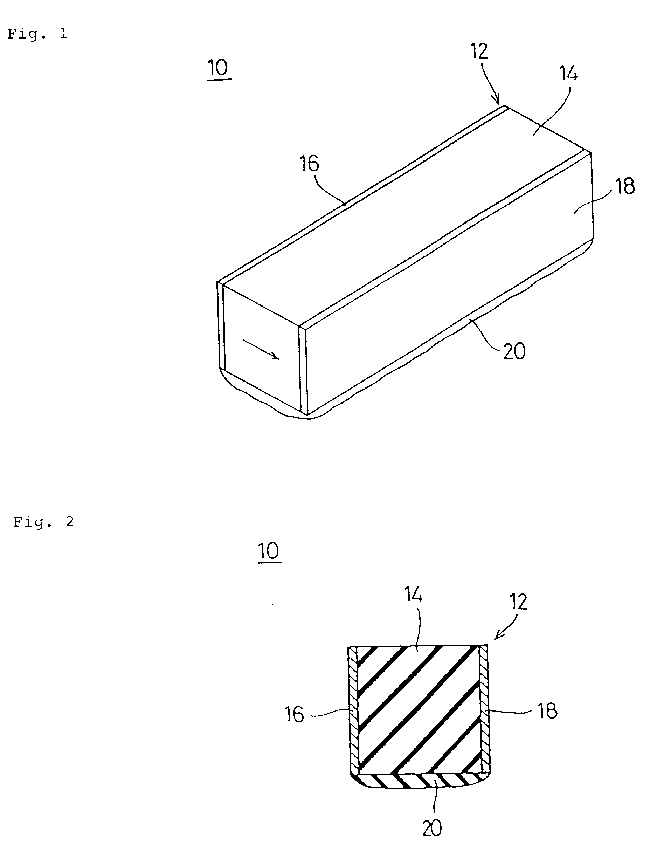

Fig. 1 is a perspective view illustrating one embodiment of the present invention, and Fig. 2 is a cross-sectional view thereof. As shown, a piezoelectric resonator 10 includes a piezoelectric resonator element 12. The piezoelectric resonator element 12 comprises a rectangular-shaped piezoelectric body 14 and external electrodes 16 and 18. The piezoelectric body 14 is polarized in a direction perpendicular to the major surfaces of the external electrodes 16 and 18 as shown by an arrow of Fig. 1. One side surface of the piezoelectric resonator element 12, on which no external electrodes 16 and 18 are formed, is covered with a resin material 20. To be specific, preferable materials for the resin material 20 include is made of for example silicone resins, urethane resins, and epoxy resins, having a JIS-A hardness of 0 to 50. In this embodiment, an urethane resin having a JIS-A hardness of 0 and having an elastic modulus of 0.1 to 10 MPa is preferably used as the resin material 20. The thickness of the resin material 10 is set to 50 µm to 100 µm. In this piezoelectric resonator 10, if a signal is applied between the external electrodes 16 and 18, longitudinal vibration occurs in the piezoelectric resonator element 12.

In this piezoelectric resonator 10 having the structure with the resin material 20, the resin material 20 acts as a load associated with the longitudinal vibration of the piezoelectric resonator element 12, and thus the presence of the resin material 20 results in changes in the characteristics, such as mechanical quality factor Qm and resonance frequency, relative to those obtained when the resin material 20 is not provided on the piezoelectric resonator element 12. However, when the piezoelectric resonator 10 is mounted on the substrate in such a manner that the resin material 20 is in contact with the substrate via an adhesive or a double-sided adhesive tape, the adhesive or the tape does not act as an additional load and thus no further change occurs in the characteristics. The characteristics of the piezoelectric resonator element 12 are mainly determined by its longitudinal length. The load associated with the longitudinal vibration of the piezoelectric resonator element 12 is substantially determined by the hardness or the elastic modulus of the resin material 20. Therefore, if the dimensions of the piezoelectric resonator element 12 and the hardness and the elastic modulus of the resin material 20 are determined properly, then it is possible to make the piezoelectric resonator 10 have desired characteristics. Specific example preferable as the substrate, on which the piezoelectric resonator 10 is mounted, include a glass epoxy substrate, an aluminum substrate, a multilayer substrate, and a dielectric substrate, which are widely used in the art.

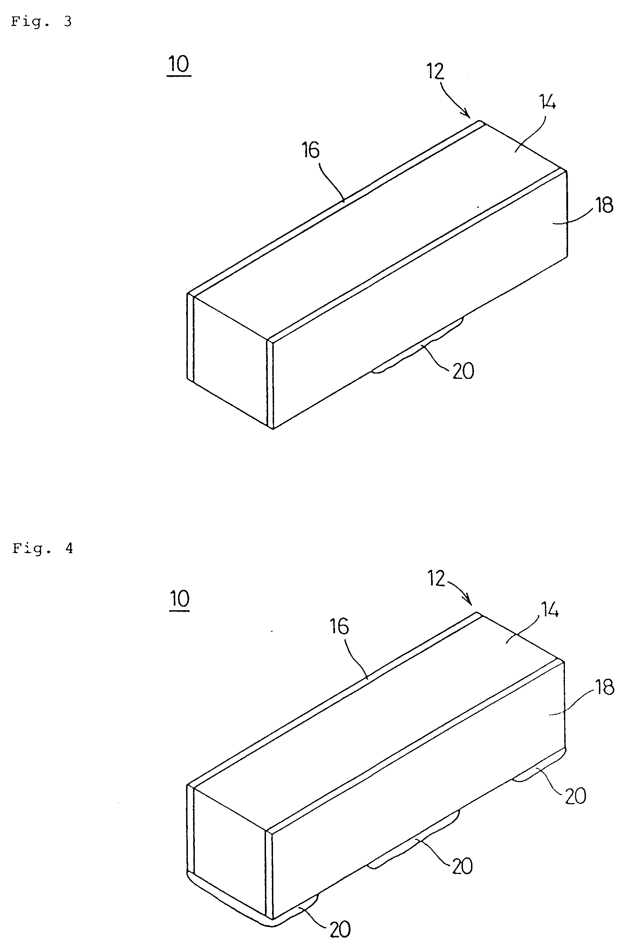

When the resin material 20 is formed on the side surface of the piezoelectric resonator element 12 on which no external electrode is provided, it is not necessarily required that the resin material 20 be formed over the entire surface. The resin material 20 may also be formed, as shown in Fig. 3, in such a manner that it is present only in a partial area, near the center in the longitudinal direction, of the side surface of the piezoelectric resonator element 12, or otherwise in both end areas in addition to the central area of the side surface of the piezoelectric resonator element 12 as shown in Fig. 4. Although the resin material 20 may be formed in various fashions as described above, it is more preferable that it be provided in the central portion of the mounting surface of the piezoelectric resonator element 12, for the following reason. When longitudinal vibration occurs in the piezoelectric resonator 10, the center of the piezoelectric resonator element 12 acts as a node of vibration. Therefore, it is preferable that the piezoelectric resonator 10 be mounted on the substrate so that the piezoelectric resonator 10 is supported at its central portion that acts as the node of vibration.

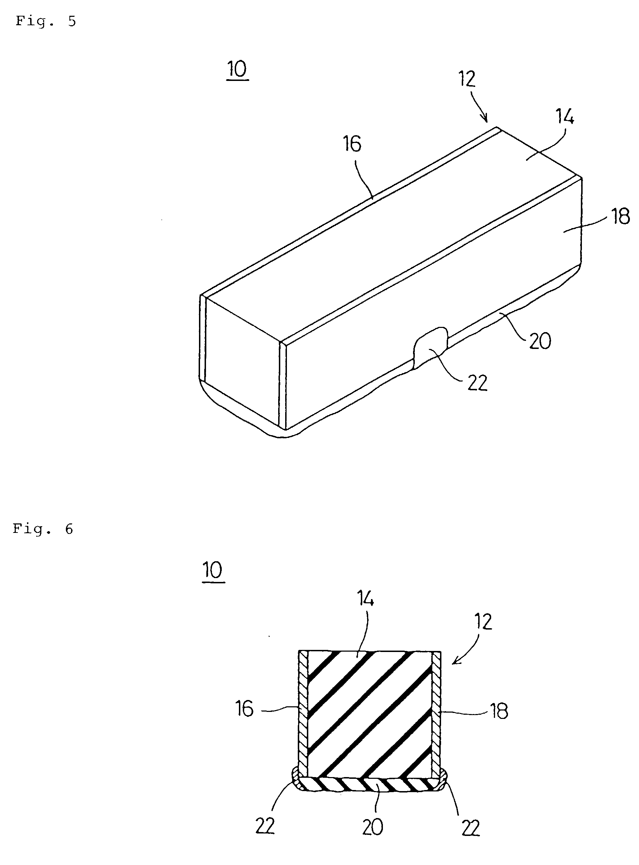

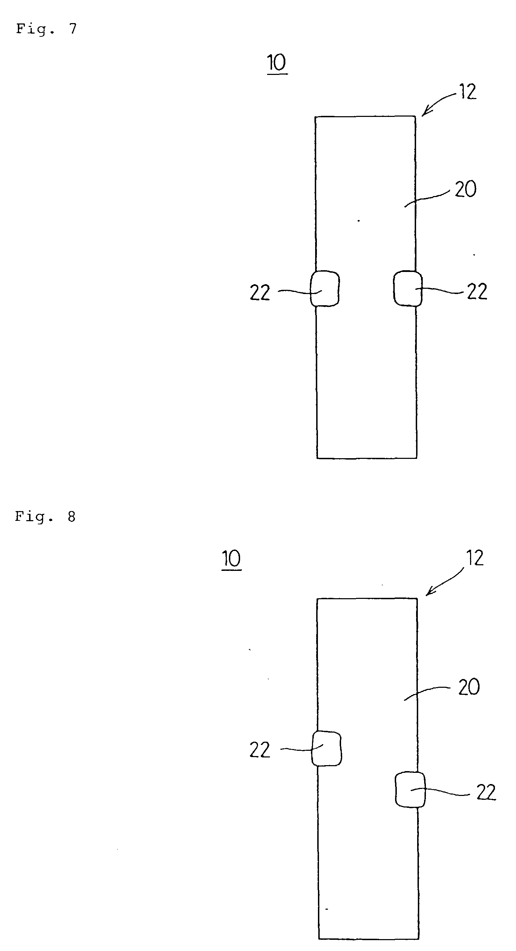

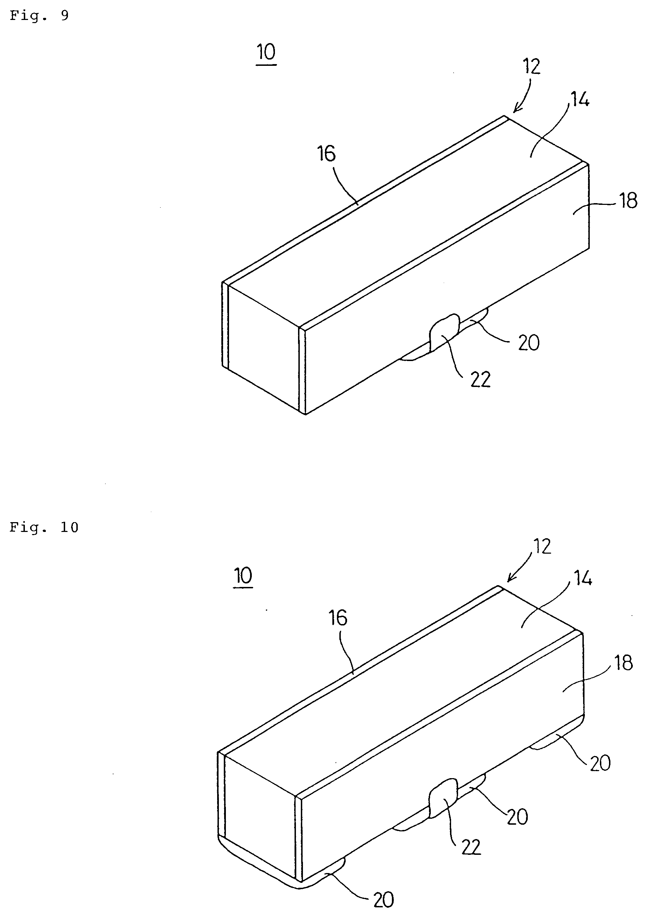

The piezoelectric resonator 10 may further have, as shown in Figs. 5 and 6, a pair of electrically conductive resin materials 22 disposed on both side surfaces, at the ends of the width and near the center in the longitudinal direction, of the piezoelectric resonator element 12. The electrically conductive resin materials 22 are formed in such a manner that they slightly extend from the end portions of the external electrodes 16 and 18 onto the surface on which the resin material 20 are formed. In this case, the electrically conductive resin materials 22 may be formed in such a manner that they are both located at the center in the longitudinal direction of the piezoelectric resonator element 12 as shown in Fit. 7, or in such a manner that they are located at positions shifted from the center in longitudinal directions as shown in Fig. 8. In the case of the piezoelectric resonator 10 having the resin material 20 formed only in the longitudinal-center area of the piezoelectric resonator element 12, or in the case of the piezoelectric resonator 10 having the resin materials 20 formed on both end portions in addition to the longitudinal-center area of the piezoelectric resonator element 12, electrically conductive resin materials 22 may also be formed as shown in Fig. 9 or 10.

It is preferable that the resin material 20 and the electrically conductive resin materials 22 be similar to each other in the thermal expansion coefficient so that the electrically conductive resin materials 22 do not peel off the resin material 20 even when used in an environment in which ambient temperature changes. For example, when a silicone resin is employed as the resin material 20, a material containing a silicone resin may be employed as the electrically conductive resin materials 22. If an urethane resin is employed as the resin material 20, a material containing an urethane resin may be employed as the electrically conductive resin materials 22.

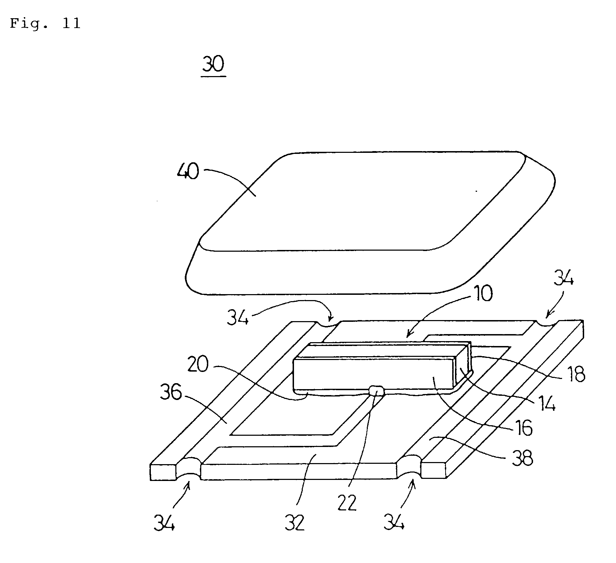

The piezoelectric resonator 10 can be used to produce an electronic component device such as a resonator and a discriminator. Fig. 11 illustrates an example of such an electronic component device. In this specific example, the electronic component device 30 includes a substrate 32 made of an insulating material such as alumina. For example two notches 34 are formed in each of opposite ends of the substrate 32. Two lead electrodes 36 and 38 are formed on the upper surface of the substrate 32. One lead electrode 36 is formed between the opposite notches 34 in such a manner that it extends from its one end into an L shape toward the central position of the substrate 32. The other lead electrode 38 is formed between the other pair of opposite notches 34 in such a manner that it extends from its one end into an L shape toward the central position of the substrate 32.

The piezoelectric resonator 10 is mounted on the substrate 32 in such a manner that the surface on which the resin material 20 is formed is in contact with the substrate 32. In this case, the end, at the central position of the substrate 32, of the lead electrode 36 and that of the lead electrode 38 are connected via an electrically conductive adhesive or the like to the respective electrically conductive resin materials 22 of the piezoelectric resonator 10. Furthermore, at least a part of the piezoelectric resonator 10 is connected to the substrate 32 in such a manner that the substrate 32 and the resin material 20 of the piezoelectric resonator 10 are bonded to each other via an electrically insulating adhesive, and the electrically conductive resin materials 22 are bonded to the lead electrodes 36 and 38 so that the external electrodes 16 and 18 are electrically connected to the lead electrodes 36 and 38. The substrate 32 is then covered with a metal cap 40. To prevent the metal cap 40 from coming into electrical contact with the lead electrode 36 and 38, the substrate 32 and the lead electrodes 36 and 38 are coated with an electrically insulating resin (not shown). When the substrate 32 is covered with the metal cap 40, the process of producing the electronic component device 30 is complete. In this electronic component device 30, the lead electrodes 36 and 38 extending onto the back surface of the substrate 32 via the notches 34 are used as input/output terminals for achieving connections to an external circuit.

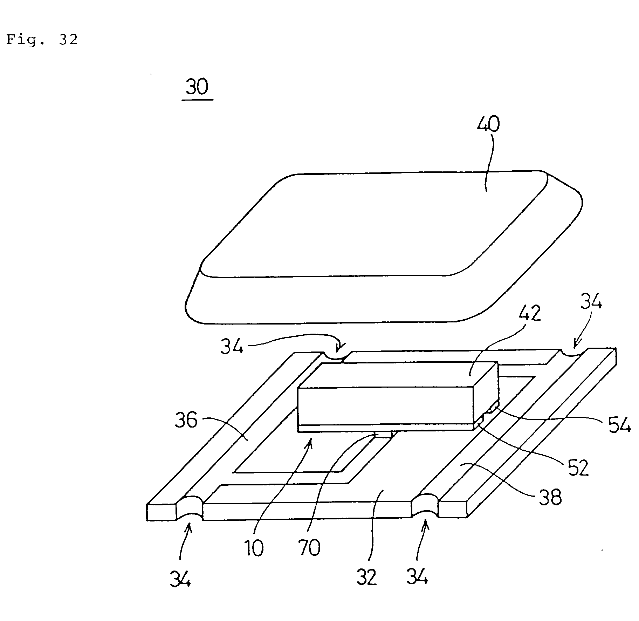

In this electronic component device 30, when a signal is applied across the piezoelectric resonator element 12 via the lead electrodes 36 and 38 and further via the electrically conductive resin materials 22, longitudinal vibration occurs in a fundamental mode in which the center of the piezoelectric resonator element 12 acts as the node of vibration. In this electronic component device 30, a soft material having a harness of 0 to 50 in units defined in the JIS-A standards is employed as the resin material 20, and thus, unlike conventional electronic component devices, it is not required that the supporting member with a large hardness have a large thickness to prevent leakage of vibration. Therefore, it is allowed to reduce the distance between the piezoelectric resonator element 12 and the substrate 32. In this structure, in spite of the small value in the thickness of the resin material 20 via which the piezoelectric resonator 10 is mounted, the presence of the resin material 20 can prevent the vibration from leaking to the substrate 32 from the piezoelectric resonator 10 thereby preventing ripples from occurring. Furthermore, the supporting member 7 having a large thickness such as that shown in Fig. 32 is not needed in this invention, and thus it is possible to achieve an electronic component device having a smaller thickness.

Furthermore in the electronic component device 30 having an electrically insulating resin formed either in the manner shown in Fig. 5 or in the manner shown in Fig. 10, unlike the case of electronic component devices employing a conventional supporting member in which a special care is required so that the supporting member has a high-precision surface, the piezoelectric resonator 10 can be easily mounted using the resin material 20 in a desirable fashion without causing the piezoelectric resonator element 12 to come into contact with the substrate 32. Furthermore, because the characteristics of the piezoelectric resonator 10 are substantially determined when the resin material 20 is formed in advance, no significant changes occur in the characteristics of the piezoelectric resonator 10 when the piezoelectric resonator 10 is mounted on the substrate 32. Therefore no adjustment of the characteristics is required after mounting the piezoelectric resonator 10. Thus neither a special high-precision process nor characteristic adjustment is required and it is possible to easily produce the electronic component device 30.

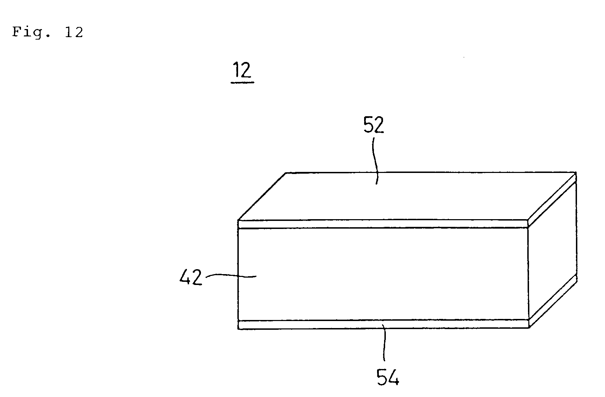

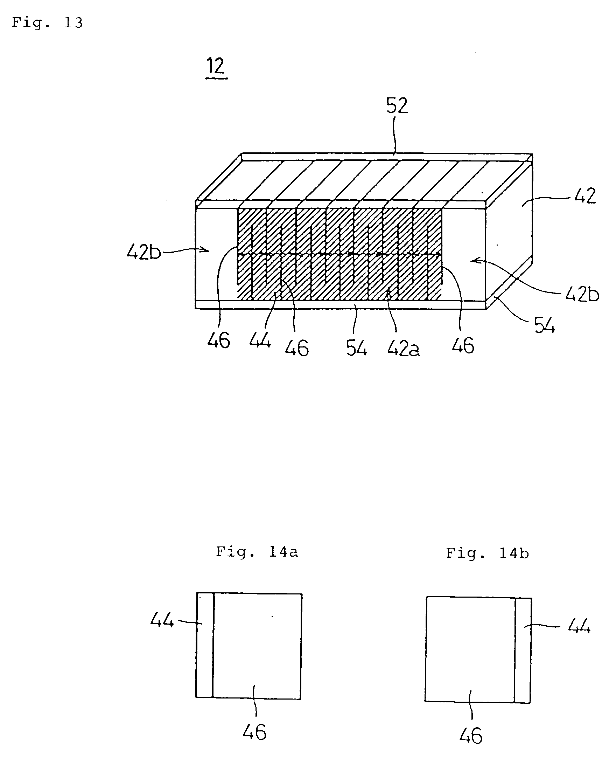

The piezoelectric resonator element 12 may also be produced into a multilayer structure as shown in Fig. 12 or 13. In this example, the piezoelectric resonator element 12 comprises a rectangular-shaped main body 42. The main body 42 is formed by disposing alternately a plurality of piezoelectric bodies 44 and internal electrodes 46. In this structure, the piezoelectric bodies 44 and the internal electrodes 46 are all disposed so that their planes are perpendicular to the longitudinal direction of the main body 42. Of adjacent internal electrodes 46, those of one type are formed for example on a piezoelectric body 44 in such a manner that the surface of the piezoelectric body 44 is covered, except for its one end portion, with the internal electrode 46 as shown in Fig. 14a, and those of the other type are formed on a piezoelectric body 44 in such a manner that the surface of the piezoelectric body 44 is covered, except for its end portion on the other side, with the internal electrode 46. The internal electrodes 46 are disposed in such a manner that different types internal electrodes are alternately located in the multilayer structure, and in such a manner that ends of the adjacent internal electrodes 46 are exposed alternately at the opposite sides of the main body 42.

The piezoelectric bodies 44 are polarized in longitudinal direction of the main body 42 such that any two piezoelectric bodies disposed on opposite sides of each internal electrode 46 are polarized in opposite directions as shown by arrows in Fig. 13. In this structure, however, both end portions 42b of the main body 42 are not polarized. The two side surfaces of the main body 42, at which the internal electrodes 46 are alternately exposed, are covered with external electrodes 52 and 54, respectively, so that one external electrode 52 is connected to one group of internal electrodes 46 and the other external electrode 54 is connected to the other group of internal electrodes 46 adjacent to the electrodes of the former group.

In this piezoelectric resonator 10, the external electrodes 52 and 54 are used as input/output electrodes. When an electric field is developed between the respective adjacent internal electrodes 46 except for both end portions, the main body 42 is excited into a piezoelectrically active state. However, because no electrodes are disposed on both end surfaces of the main body 42, no electric field is developed in both end portions of the main body 42, and thus the main body 42 is not polarized in these end portions and these end portions remain in a piezoelectrically inactive state. In other words, when an input signal is applied, an active region 42a is formed in the central portion of the main body 42 as shown by the diagonally shaded region in Fig. 13, while inactive regions 42b are formed in both end portions of the main body 42. In these inactive regions 42b, no driving force is generated when the input signal is applied. The inactive regions may also be formed if no polarization occurs between internal electrodes when an electric field is developed between the internal electrodes. Or otherwise, the inactive regions may be formed into a structure in which no electric field is developed across piezoelectric body layers which are polarized. In the present intention, the inactive regions 42b are not necessarily needed, and the entire portion of the main body may be an active region.

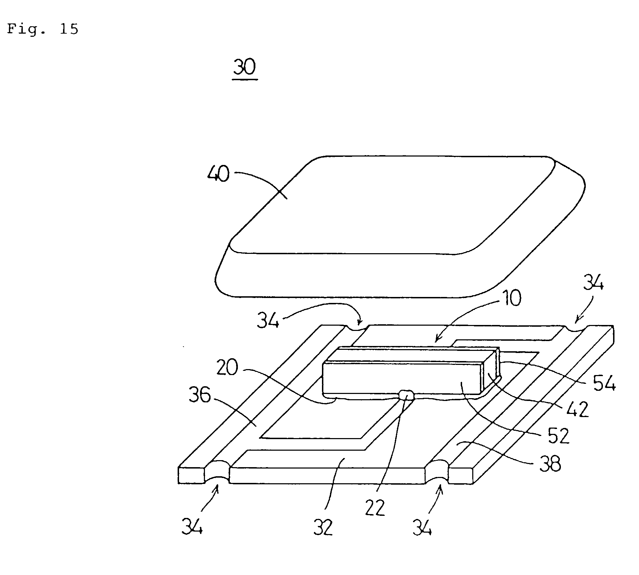

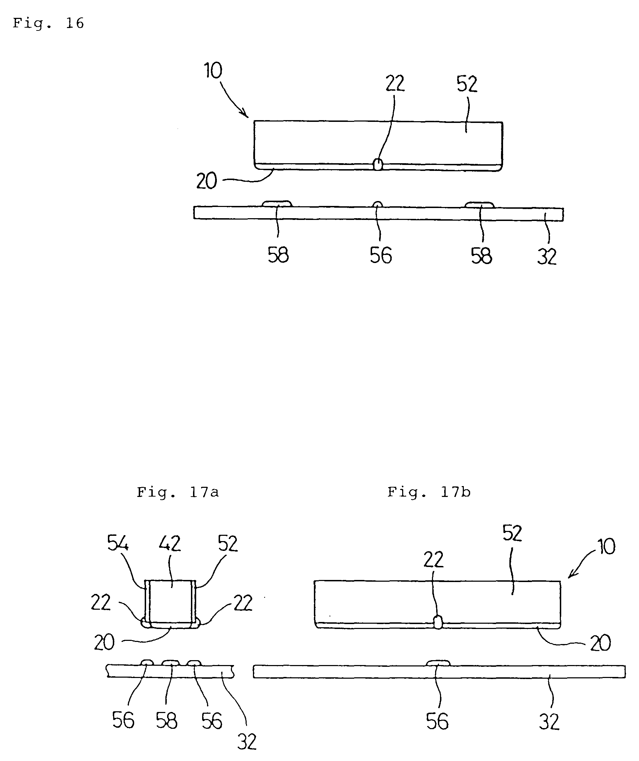

One side surface of the main body 42, on which no external electrodes 52 and 54 are formed, is covered with a resin material 20 and an electrically conductive resin materials 22, as in the case of the structure shown in Figs. 5 and 6. The above-described piezoelectric resonator 10 is mounted on the substrate 32 as shown in Fig. 15. And, as shown in Fig. 16, the electrically conductive resin materials 22 are connected via an electrically conductive adhesive 56 or the like to lead electrodes 36 and 38, respectively, provided on the substrate 32. The piezoelectric resonator 10 is bonded, at its both ends in the longitudinal direction, to the substrate 32 via an electrically insulating adhesive 58. Alternatively, as shown in Figs 17(a) and 17(b), an electrically insulating adhesive 58 may be coated on the substrate 32, in an area between the electrically conductive adhesives 56 on the lead electrodes 36 and 38, and the piezoelectric resonator 10 may be bonded to the substrate 32 via the electrically insulating adhesive 58. As a result, the lead electrodes 36 and 38 on the substrate 32 are electrically connected via the electrically conductive resin materials 22 to the external electrodes 52 and 54 on the piezoelectric resonator element 12. Then the substrate 32 is covered with a metal cap 40, and thus an electronic component device 30 in a complete form is obtained.

In this electronic component device 30, when a signal is applied via the lead electrodes 36 and 38 and the electrically conductive resin materials 22 shown in Fig. 15, a voltage is applied in opposite directions across the respective piezoelectric bodies 44 of the main body 42 that are polarized in opposite directions. As a result, the piezoelectric bodies 44 as a whole are expanded and contracted in the same direction. As a result, the piezoelectric resonator 10 as a whole is excited so that longitudinal vibration occurs in which the center of the main body 42 acts as a node of vibration. Although in the specific example described above, piezoelectric bodies disposed on opposite sides of each internal electrode 46 are polarized in opposite directions, the polarization is not limited to such direction as long as the piezoelectric resonator 10 may be excited into longitudinal vibration.

In this electronic component device 30, the polarization of the piezoelectric bodies 44 of the piezoelectric resonator 10, the electric field developed in response to a signal, and the vibration of the piezoelectric bodies 44 all occur along the same axis. That is, this piezoelectric resonator 10 is a resonator of the type based on the longitudinal piezoelectric effect. The piezoelectric resonator 10 based on the longitudinal piezoelectric effect has a greater electromechanical coupling coefficient than piezoelectric resonators based on the transverse piezoelectric effect in which vibration occurs in a different direction from the polarization direction. As a result, the piezoelectric resonator 10 based on the longitudinal piezoelectric effect has a greater difference ΔF between the resonant frequency and the antiresonant frequency. This makes it possible to obtain a greater bandwidth.

In the piezoelectric resonator 10 having the structure described above, ΔF can be adjusted by controlling the ratio of the position of the active region 42a to that of the inactive regions 42b or by controlling the locations where the inactive regions 42b are formed. Furthermore, it is possible to adjust the capacitance of the piezoelectric resonator 10 by properly selecting the number of layers of the active region 42a. This makes it possible to easily make the electronic component device 30 matched in impedance with an external circuit.

Also in the case where the piezoelectric resonator 10 is constructed into the multilayer form described above, the characteristics of the piezoelectric resonator 10 are substantially determined when the resin material 20 is formed in advance, and thus no further significant change occurs during the following process in which the piezoelectric resonator 10 is mounted on the substrate 32. Furthermore, since a soft material is employed as the resin material 20, it is allowed to reduce the distance between the piezoelectric resonator 10 and the substrate 32 thus preventing the vibration leakage and ripples. Therefore, it is possible to produce the electronic component device 30 into a smaller-sized form. Furthermore, the electronic component device 30 can be easily produced without having to take special care on the dimensional accuracy or on the adjustment after the mounting process.

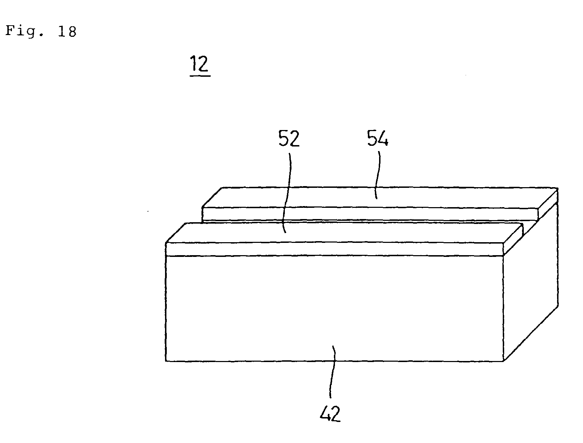

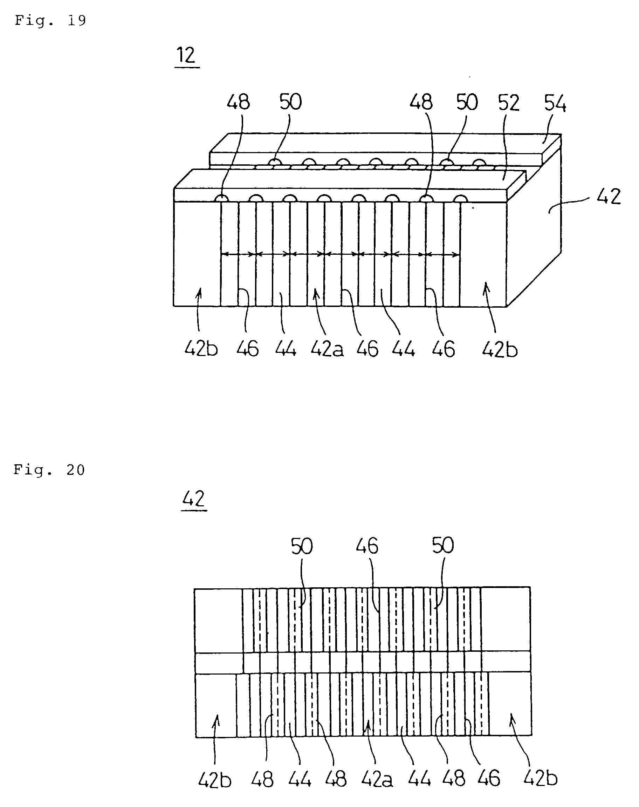

In another embodiment of the invention, two external electrodes 52 and 54 are both formed on one side surface of the main body 42, as shown in Figs. 18 and 19. In Figs. 18 and 19, internal electrodes 46 are formed over the entire areas of the respective layers disposed in a direction perpendicular to the longitudinal direction of the main body 42. Furthermore, as shown in Fig. 20, insulating films 48 and 50 are formed on the above-described one side surface of the main body 42 in such a manner that exposed end portions of the respective internal electrodes 46 are covered with the insulating films 48 and 50. A first group of insulating films 48 are formed in one side area extending along the longitudinal direction of the main body 42 in such a manner that every two internal electrodes 46 are covered with the insulating films 48. The second group of insulating films 50 are formed in the opposite side area extending along the longitudinal direction of the main body 42 in such a manner as to cover the remaining internal electrodes 46 which are not covered with the insulating film 48. Thus, the end portions of the internal electrodes 46 exposed at the one side surface of the main body 42 are alternately covered with the two insulating films 48 and 50. The insulating films 48 are disposed side by side (in parallel to each other) in one side area extending along the longitudinal direction of the main body 42, and the insulating films 50 are disposed side by side (in parallel to each other) in the opposite side area extending along the longitudinal direction of the main body 42.

Two external electrodes 52 and 54 are formed on the above-described one side surface of the main body 42 in such a manner that they are located in either side and extend along the longitudinal direction of the main body 42. The external electrode 52 is located along a straight line in the side area of the main body 42 where the insulating films 48 are formed. The external electrode 54 is located along a straight line in the opposite side area of the main body 42 where the insulating films 50 are formed. Thus, the external electrode 52 is connected to the internal electrodes 46 whose end portion is not covered with the insulating films 48, and the external electrode 54 is connected to the internal electrodes 46 whose end portion is not covered with the insulating films 50. That is, one of each pair of adjacent internal electrodes 46 is connected to one external electrode 52, and the other of each pair of adjacent internal electrodes 46 is connected to the other external electrode 54.

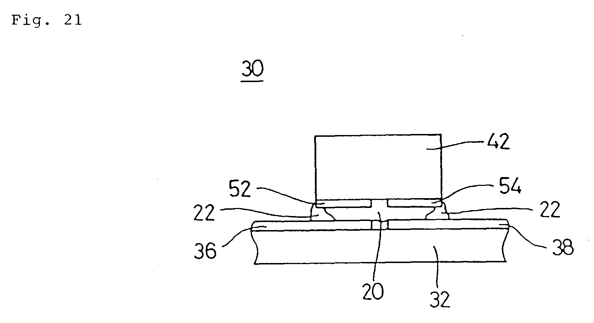

The above-described one side surface of the main body 42, on which the external electrodes 52 and 54 are formed, is coated with a resin material 20 as shown in Fig. 21. The resin material 20 is formed in an area between the external electrodes 52 and 54. Furthermore, electrically conductive resin materials 22 are formed on both ends of the width direction of the piezoelectric resonator element 12, at central locations in the longitudinal direction of the piezoelectric resonator element 12. These electrically conductive resin materials 22 are connected to the external electrodes 52 and 54, respectively. This piezoelectric resonator 10 is mounted on a substrate 32 in such a manner that the external electrodes 52 and 54 are electrically connected via the electrically conductive resin materials 22 to the lead electrodes 36 and 38, respectively, provided on the substrate 32. Finally, the substrate 32 is covered with a metal cap (not shown), and thus an electronic component device 30 in a complete form is obtained.

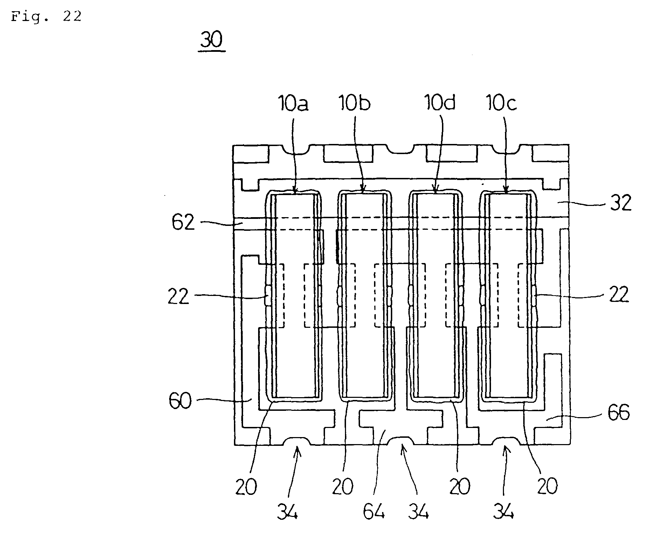

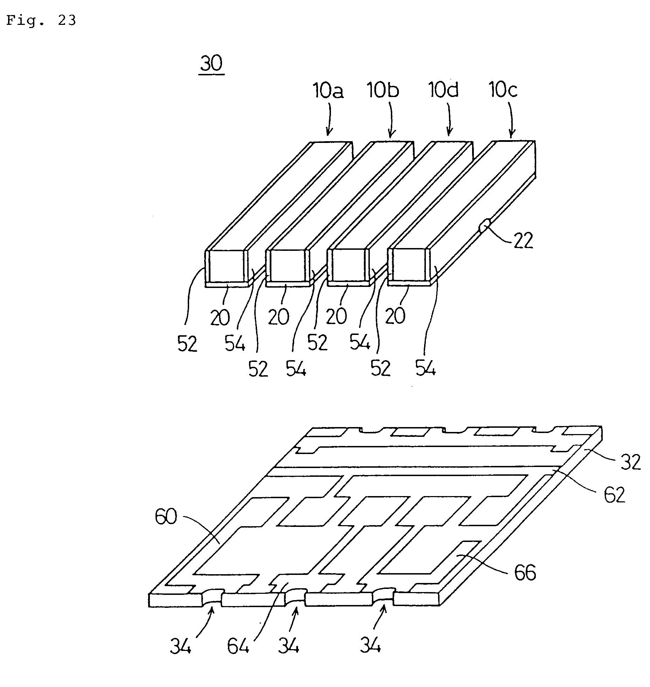

Fig. 22 is a plan view illustrating the main parts of an electronic component device 30 constructed into the form of a ladder filter with a plurality of piezoelectric resonators, and Fig. 23 is a perspective view thereof. This electronic component device 30 has four lead electrodes 60, 62, 64, and 66 formed on a substrate 32. There are provided five lands which are formed on the substrate 32 in such a manner that they are properly spaced from each other and disposed in a line. The first land located on one end portion of the substrate 32 is connected to the lead electrode 60. The second and fifth lands are connected to the lead electrode 62. The third land is connected to the lead electrode 64, and the fourth land is connected to the lead electrode 66.

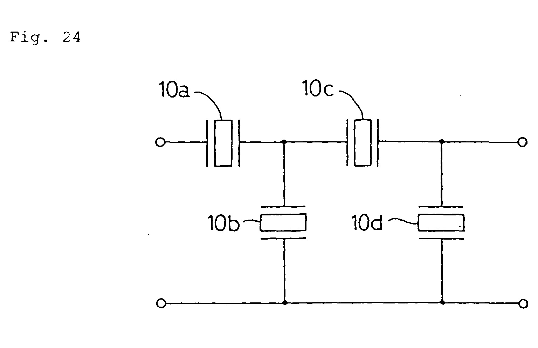

Piezoelectric resonators 10a, 10b, 10c, and 10d having a structure similar to that shown in Fig. 12 and 13 are mounted on the substrate 32 so that the external electrodes 52 and 54 of each piezoelectric resonator are connected to corresponding two lands, thereby achieving a ladder circuit as shown in Fig. 24. As in the embodiment shown in Fig. 11, the substrate 32 is covered with a metal cap (not shown).

This electronic component device 30 acts as a ladder filter whose equivalent circuit is shown in Fig. 24. In this circuit, for example two piezoelectric resonators 10a and 10c act as series resonators and the other two piezoelectric resonators 10b and 10d act as parallel resonators. In this ladder filter, the parameters are designed so that the capacitance of the parallel piezoelectric resonators 10b and 10d is much greater than the capacitance of the series piezoelectric resonators 10a and 10c. A similar ladder filter may also be constructed using piezoelectric resonators each having a structure similar to that of the piezoelectric resonator 10 shown in Figs. 18 and 19 in which external electrodes 52 and 54 are formed on one side surface of the main body 42.

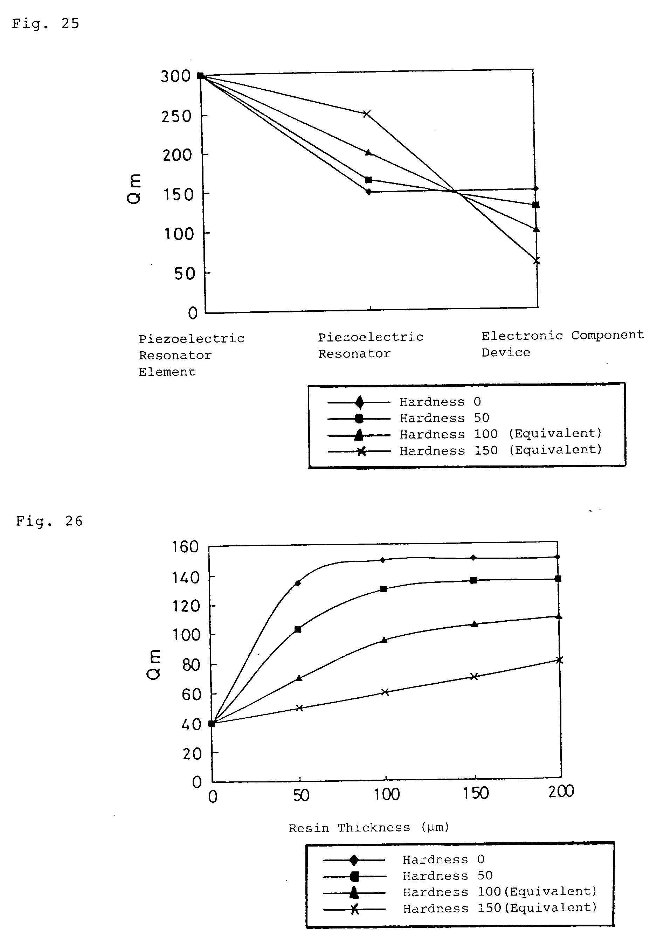

Also in this case where the electronic component device 30 is constructed using a plurality of piezoelectric resonators 10, the presence of the resin material 20 makes it possible to easily produce the electronic component device into a small form having reliable and stable characteristics. In the present invention, as described above, the hardness of the resin material 20 is limited with the range from 0 to 50 in units defied in the JIS-A standards so that no significant change occurs in the characteristics during the process in which the resin material 20 is coated on the piezoelectric resonator element 12 and then the piezoelectric resonator element is mounted on the substrate 32. This is apparent from the experimental results shown in Figs. 25 and 26.

Fig. 25 illustrates the mechanical quality factor Qm for the piezoelectric resonator element 12, the piezoelectric resonator 10 having the resin material 10, and the electronic component device 30 comprising the piezoelectric resonator 10 mounted on the substrate 32. Fig. 26 illustrates Qm as a function of the thickness of the resin material 20 of the piezoelectric resonator 10. Although the maximum value of the hardness defined in the JIS-A standards is 99, some calculated equivalent values shown in Figs. 25 and 26 are greater than the maximum value.

As can be seen from Fig. 25, in the case where the resin material has a hardness of 0 or 50, substantially no change in Qm is observed between the value obtained before and that after mounting the piezoelectric resonator 10 on the substrate 32. In contrast, in the case where the resin material has a hardness corresponding to 100 or 150 in units defined in the JIS-A standards, great changes in Qm occur when the piezoelectric resonator is mounted on the substrate. From Fig. 26, it can be seen that when the thickness of the resin material 20 is varied, a small change occur in Qm for the JIS-A hardness of 0 or 50 while a great change occurs in Qm for the equivalent JIS-A hardness of 100 or 150. In the case where the resin material has a JIS-A hardness of 0 or 50, stable characteristics can be obtained in the thickness range greater than 50 µm.

As described above, if the resin material has a hardness within the range from 0 to 50 in units defined in the JIS-A standards, it is possible to achieve stable characteristics in the piezoelectric resonator 10, and thus no adjustment is required after mounting the piezoelectric resonator on the substrate.

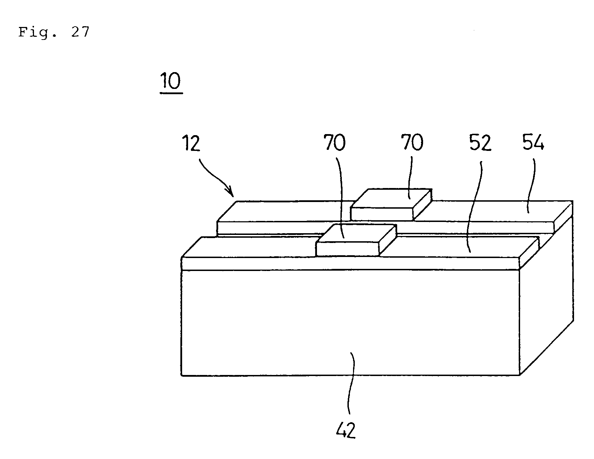

In the above embodiments, the resin material is formed on the piezoelectric resonator element for use in the piezoelectric resonator or the piezoelectric component device. Instead, as shown in Fig. 27, supporting members 70 made of an electrically conductive resin with an elastic modulus of 0.1 to 10 MPa may be employed. In this specific example, a piezoelectric resonator element similar to that shown in Fig. 18 is used, and supporting members 70 are disposed on the external electrodes 52 and 54, respectively, at the center in the longitudinal direction of the piezoelectric resonator element 12. The supporting members 70 are formed so that they have a width substantially equal to the width of the external electrodes 52 and 54. Examples preferable as the electrically conductive resin include silicone resins, urethane resins, and soft epoxy resins. The supporting members 70 are boned via an adhesive to the lead electrodes 36 and 38, respectively, of the substrate 32. As for the adhesive for this purpose, for example an electrically conductive epoxy adhesive may be employed. In the piezoelectric resonator 10 constructed in the above-described manner, a signal is applied between the external electrodes 52 and 54 via the lead electrodes 36 and 38 and further via the supporting members 70.

Also in this piezoelectric resonator 10, the presence of the supporting members 70 made of the electrically conductive resin having an elastic modulus of 0.1 to 10 MPa prevents vibration from leaking to the substrate 32 from the piezoelectric resonator 10 thus preventing ripples from occurring. Furthermore, after forming the supporting members 70 in advance, no additional load to the longitudinal vibration is generated when the piezoelectric resonator 10 is mounted on the substrate 32. As a result, no significant changes occur in the characteristics when the piezoelectric resonator 10 is mounted on the substrate 32.

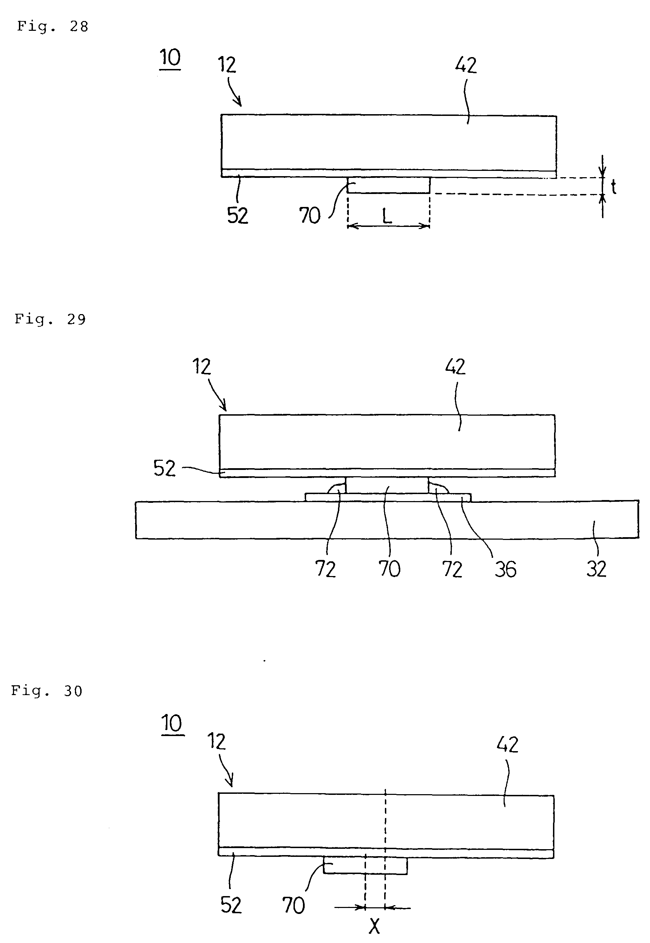

In the piezoelectric resonator 10, if the elastic modulus of the supporting members 70 are controlled within the range from 0.1 to 10 MPa, then the vibration leakage is suppressed regardless of the size of the supporting members 70. That is, as shown in Fig. 28, the vibration leakage in the piezoelectric resonator 10 is suppressed regardless of the length L and the thickness t of the supporting members 70. When the piezoelectric resonator 10 is mounted on the substrate 32, the adhesive 72 can be partially deposited on the side wall of the supporting members 70, as shown in Fig. 29. In particular when a hard epoxy adhesive having a great adhesion strength is employed, it is required to set the thickness t of the supporting members 70 to a value greater than the height of the part of the epoxy adhesive 72 deposited on the side wall. If the adhesive 72 comes into contact with the piezoelectric resonator element 12, vibration leakage can occur via the adhesive 72.

It is not necessarily required that the supporting members 70 be formed at the center in the longitudinal direction of the piezoelectric resonator element 12, but they may also be formed at locations shifted from the center, as shown in Fig. 30, without encountering a significant increase in vibration leakage. As described above, it is possible to achieve low vibration leakage from the piezoelectric resonator 10 regardless of the length L and the thickness t of the supporting members 70 and regardless of the shift X from the center of the piezoelectric resonator element 12. However, the mechanical quality factor Qm of the piezoelectric resonator 10 decreases with the increase in L, t, and X. Therefore, the dimensions of the supporting members 70 should be determined within a range in which a desired value of Qm is obtained.

In this embodiment, it is also possible to employ a piezoelectric resonator element 12 constructed into a form similar to that shown in Fig. 1 in which the external electrodes 16 and 18 are formed on two opposite side surfaces of the rectangular-shaped piezoelectric body 14 which is polarized in a direction perpendicular to the external electrodes 16 and 18. In this case, two supporting members may be formed on one side surface of the piezoelectric body 14 at which end portions of both external electrodes 16 and 18 are exposed. These supporting members 70 are formed in such a manner that they are electrically connected to the external electrodes 16 and 18, wherein the electric connections are realized at the center in the longitudinal direction of the piezoelectric resonator element 12 and at both ends in the width direction of the piezoelectric resonator element 12. Also in the case where the piezoelectric resonator 10 having the above-described structure is employed, vibration leakage from the piezoelectric resonator element 12 is prevented by the supporting members 70. Furthermore, the supporting members 70 can be used to realize electric connections of the external electrodes 16 and 18 of the piezoelectric resonator element 12 to the lead electrodes formed on the substrate. Qm of the piezoelectric resonator 10 can be adjusted by properly selecting the dimensions of the supporting members 70.

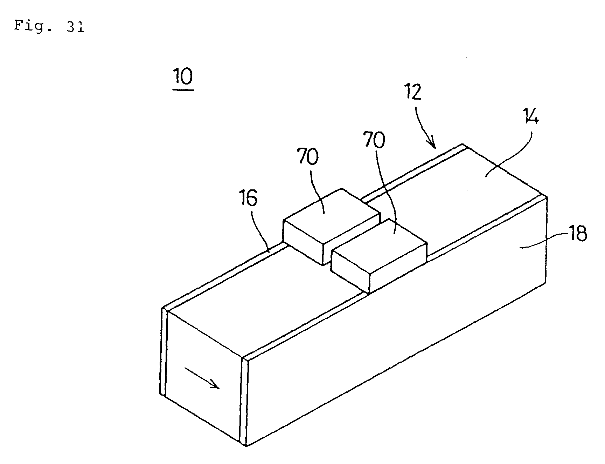

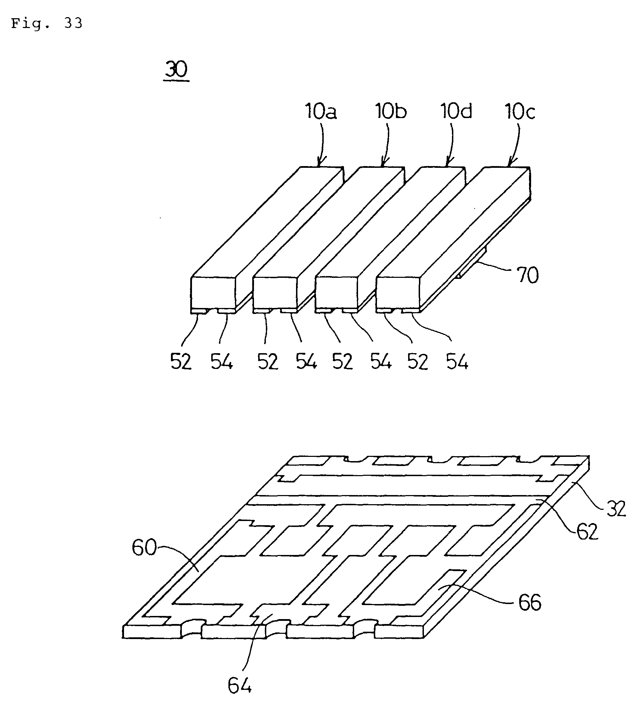

As described above, reliable characteristics can be achieved in the piezoelectric resonator 10 also in the case where the supporting members are made of a resin having an elastic modulus of 0.1 to 10 MPa. Thus, no characteristic adjustment is required after mounting the piezoelectric resonator 10 on the substrate 32 into the electronic component device 30 as shown in Fig. 32. Furthermore, a ladder filter such as that shown by the equivalent circuit diagram of Fig. 24 can also be realized using the piezoelectric resonators 10 having the above-described supporting members 70 as shown in Fig. 33. In the electronic component devices shown in Figs. 32 and 33, the piezoelectric resonators 10 used are not limited to the type shown in Fig. 27, but the piezoelectric resonators of the type shown in Fig. 31 may also be employed.

## Claims

1. A piezoelectric resonator (10) comprising:
a piezoelectric resonator element (12) utilizing longitudinal vibration mode and having a mounting surface;
characterized in that
a resin material (20) is provided on the mounting surface of said piezoelectric resonator element, and said resin material has a hardness of 0 to 50 in units defined in the JIS-A standards.

2. A piezoelectric resonator comprising:
a piezoelectric resonator element (12) utilizing longitudinal vibration mode and having a mounting surface;
characterized in that
a resin material (20) is provided on the mounting surface of said piezoelectric resonator element (12), and said resin material (20) has an elastic modulus of 0.1 to 10 MPa.

3. The piezoelectric resonator according to Claim 1, characterized in that said resin material (20) has an elastic modulus of 0.1 to 10 MPa.

4. The piezoelectric resonator according to any one of Claims 1 to 3, characterized in that:
said piezoelectric resonator has a longitudinal direction, and said resin material (20) is located at least at the center in the longitudinal direction of said piezoelectric resonator element (12).

5. The piezoelectric resonator according to any one of Claims 1 to 4, characterized in that:
said piezoelectric resonator element comprises a pair of external electrodes (16, 18); and
a pair of electrically conductive resin materials (22) are connected to said pair of external electrodes (16, 18) respectively at the center in the longitudinal direction of said piezoelectric resonator element (12).

6. The piezoelectric resonator according to Claim 5, characterized in that:
each of said pair of external electrodes (16, 18) is plane shape,
said piezoelectric resonator element (12) comprises said pair of external electrodes (16, 18) and a piezoelectric body (14) disposed between said external electrodes, and said piezoelectric body (14) is polarized in a direction perpendicular to the plane of said external electrodes (16, 18).

7. The piezoelectric resonator according to Claim 5, characterized in that:
said piezoelectric resonator (12) element comprises a main body (42) having a longitudinal direction, said main body (42) comprises at least two plane shaped internal electrodes (46) perpendicular to said longitudinal direction and a piezoelectric body (44) disposed between said internal electrodes (46), said piezoelectric body (44) is polarized in a direction along the longitudinal direction of said main body, and said pair of internal electrodes (46) are connected to said pair of external electrodes (52, 54) respectively.

8. The piezoelectric resonator according to any one of Claims 5 to 7, characterized in that:
the thermal expansion coefficient of said resin material (20) is substantially equal to that of said electrically conductive resin materials (22).

9. The piezoelectric resonator according to any one of Claims 1 to 4, characterized in that:
said piezoelectric resonator element comprises a main body (42) having a longitudinal direction and a pair of external electrodes (52, 54) provided on the mounting surface of said main body or provided in such a manner that they are exposed at the mounting surface, and a pair of said resin material (22) are electrically conductive, disposed on the mounting surface of said main body (42), and electrically connected to said pair of external electrodes (52, 54) respectively.

10. The piezoelectric resonator according to Claim 9, characterized in that said resin materials (20) are located at the center in the longitudinal direction of said piezoelectric resonator element on the mounting surface.

11. The piezoelectric resonator according to Claim 9, characterized in that:
each of said pair of external electrodes is plane shape,
said piezoelectric resonator element (12) comprises said pair of external electrodes (52, 54) and a piezoelectric body (14) disposed between said external electrodes, and said piezoelectric body is polarized in a direction perpendicular to the plane of said external electrodes.

12. The piezoelectric resonator according to Claim 9, characterized in that:
said piezoelectric resonator element comprises a main body (42) having a longitudinal direction, said main body comprises at least two plane shaped electrodes (46) perpendicular to said longitudinal direction and a piezoelectric body (44) disposed between said plane shaped electrodes, said piezoelectric body (44) is polarized in a direction along the longitudinal direction of said main body, and said pair of plane shaped electrodes are connected to said pair of external electrodes respectively.

13. An electronic component device using the piezoelectric resonator of any one of Claims 1 to 8, wherein said piezoelectric resonator (10) is mounted on a substrate via said resin material (20).

14. An electronic component device using the piezoelectric resonator of any one of Claims 5 to 8, wherein said piezoelectric resonator is mounted on a substrate via said resin material (20), and said external electrodes (52, 54) are connected via said electrically conductive resin materials (22) to lead electrodes (36, 38) provided on said substrate.

15. The electronic component device according to Claim 14, wherein said electrically conductive resin materials (22) of the piezoelectric resonator (10) are connected to said lead electrodes (36, 38) via an electrically conductive adhesive.

16. The electronic component device using a piezoelectric resonator of any one of Claims 9 to 12, wherein said piezoelectric resonator (10) is mounted on the substrate via said electrically conductive resin materials (22).

17. The electronic component device according to Claim 16, wherein said external electrodes are electrically connected via said electrically conductive resin materials (22) to lead electrodes (36, 38) provided on the substrate.

18. The electronic component device according to Claim 17 wherein said electrically conductive resin materials (22) are fixed via an electrically conductive adhesive to said lead electrodes, respectively.

19. The electronic component device according to any one of Claims 9 to 18, wherein a plurality of said piezoelectric resonators (10a, 10b, 10c, 10d) are disposed on said substrate and connected in such a manner as to form a ladder filter.
